## Europäisches Patentamt

(19) **European Patent Office**

**Office européen des brevets**

(11) Veröffentlichungsnummer: **0 041 472**
**B1**

(12) # EUROPÄISCHE PATENTSCHRIFT

(45) Veröffentlichungstag der Patentschrift:
**05.12.84**

(51) Int. Cl.³: **H 04 R 3/08, H 03 F 1/38**

(21) Anmeldenummer: **81730052.8**

(22) Anmeldetag: **21.05.81**

(54) **Schaltungsanordnung mit Verstärker und nachgeschaltetem Übertrager.**

(30) Priorität: **31.05.80 DE 3021007**

(43) Veröffentlichungstag der Anmeldung:
**09.12.81 Patentblatt 81/49**

(45) Bekanntmachung des Hinweises auf die Patenterteilung:
**05.12.84 Patentblatt 84/49**

(84) Benannte Vertragsstaaten:
**AT CH DE LI NL**

(56) Entgegenhaltungen:
**DE - A - 2 641 581**
**DE - A - 2 713 023**
**DE - A - 2 846 381**
**DE - A - 2 901 567**
**US - A - 3 134 080**

(73) Patentinhaber: **ANT Nachrichtentechnik GmbH, Gerberstrasse 33, D-7150 Backnang (DE)**

(72) Erfinder: **Baudisch, Werner, Ing. grad, Lindener Strasse 31, D-3340 Wolfenbüttel (DE)**

(74) Vertreter: **Schickle, Gerhard, Dipl.-Ing. et al, ANT Nachrichtentechnik GmbH Patent- und Lizenzabteilung Gerberstrasse 33, D-7150 Backnang (DE)**

ACTORUM AG

## Beschreibung

Die Erfindung bezieht sich auf eine Schaltungsanordnung nach dem Oberbegriff des Patentanspruches 1 oder 2.

Sie ist anwendbar auf einen Übertrager, beispielsweise einen Ausgangsübertrager, dem ein Verstärker vorgeschaltet ist. Eine solche Anordnung weist eine Reihe von unerwünschten Eigenschaften auf: beispielsweise verschlechtert sich bei tiefen Frequenzen der Frequenzgang und bei Vollaussteuerung der Klirrfaktor; ausserdem treten unerwünschte Erhöhungen des Ausgangsscheinwiderstandes auf.

Möglich wäre eine Verbesserung mit einer Gegenkopplungsschaltung, wobei die Gegenkopplungsspannung einer zusätzlichen Wicklung auf dem Übertrager entnommen werden oder über einen zusätzlichen Übertrager rückgeführt werden kann (US-A-3 134 080). Diese zusätzliche Wicklung stellt aber bereits einen relativ hohen Aufwand dar, und es ergeben sich durch die Gegenkopplungsschaltung Stabilitätsprobleme.

Es ist Aufgabe der Erfindung, ganz allgemein eine Verringerung des Klirrfaktors zu erzielen für den Fall, dass eine elektrische Grösse (Strom oder Spannung) durch einen komplexen Leitwert bzw. am Ausgang eines Übertragers nicht die gewünschte Form (Amplitude, Phasenlage oder Kurvenform) hat, sondern infolge eines Zweigstromes durch eine unerwünschte Komponente des komplexen Leitwertes bzw. infolge eines Spannungsabfalls an einer unerwünschten Impedanzkomponente des Übertragers eine Abweichung aufweist von der gewünschten Form.

Diese Aufgabe wird gelöst durch die Schaltungsanordnung nach Patentanspruch 1 bzw. 2. Vorteilhafte Weiterbildungen der Erfindung sind in den Unteransprüchen angegeben.

Die Erfindung kann zur Verminderung des Klirrfaktors von Übertragern verwendet werden. Bei deren Betrieb kommt es nämlich u.a. deshalb zu unerwünschtem Klirren, weil beispielsweise trotz sinusförmiger Spannung an den Eingangsklemmen an der Hauptinduktivität eine verzerrte Spannung auftritt. Die Verzerrung kommt dadurch zustande, dass infolge der nichtlinearen Eigenschaften des Eisenkerns die Reihenschaltung der Ersatzimpedanzen (beispielsweise Hauptinduktivität und Kupferwiderstand) ein nichtlineares Verhalten zeigt mit der Folge, dass trotz sinusförmiger Eingangsspannung ein nicht sinusförmiger Strom durch die Reihenschaltung fliesst, der am linearen Kupferwiderstand einen Spannungsabfall von nicht sinusförmiger Kurvenform erzeugt. Dieser Spannungsabfall subtrahiert sich von der Eingangsspannung, so dass an der Hauptinduktivität eine nicht sinusförmige Restspannung verbleibt, die zwangsläufig zu Verzerrungen der Ausgangsgrösse führt. Durch die Erfindung kann der störende, nichtlineare Spannungsabfall am Kupferwiderstand und/oder anderen störenden Ersatzimpedanzen völlig oder teilweise kompensiert werden.

Gerade bei Übertragern mit magnetisierbarem Kern, z.B. Eisenkern, ist die Ausgangsübrtrager-Ausgangsspannung mit einem Klirrfaktor behaftet. Durch die erfindungsgemässe Art von Rückkopplung, für die jedoch keine zusätzliche Wicklung auf dem Übertrager erforderlich ist, konnten diese fehlerhaften Eigenschaften eines Übertragers kompensiert werden.

Zusätzlich hat sich gezeigt, dass mit den Kompensationsmassnahmen auch oder stattdessen Einfluss genommen werden kann auf das Frequenzverhalten und/oder den Ausgangswiderstand der Schaltungsanordnung.

Anhand der Zeichnungen wird die Erfindung nunmehr erläutert, und es wird auf Ausführungsbeispiele eingegangen.

Es zeigen:

Fig. 1: eine Schaltungsanordnung für eine Impedanz, die eine Serienschaltung von Ersatzimpedanzen aufweist,

Fig. 2: eine Schaltungsanordnung für eine Impedanz bzw. einen komplexen Leitwert, der in dualer Weise zu Fig. 1 durch eine Parallelschaltung von Ersatzleitwerten angenähert werden kann,

Fig. 3: abgeänderte Schaltungsdetails gegenüber Fig. 2,

Fig. 4: eine Schaltungsabwandlung zu Fig. 1,

Fig. 5 bis 8: detailliertere Ausführungsbeispiele in Anlehnung an Fig. 1.

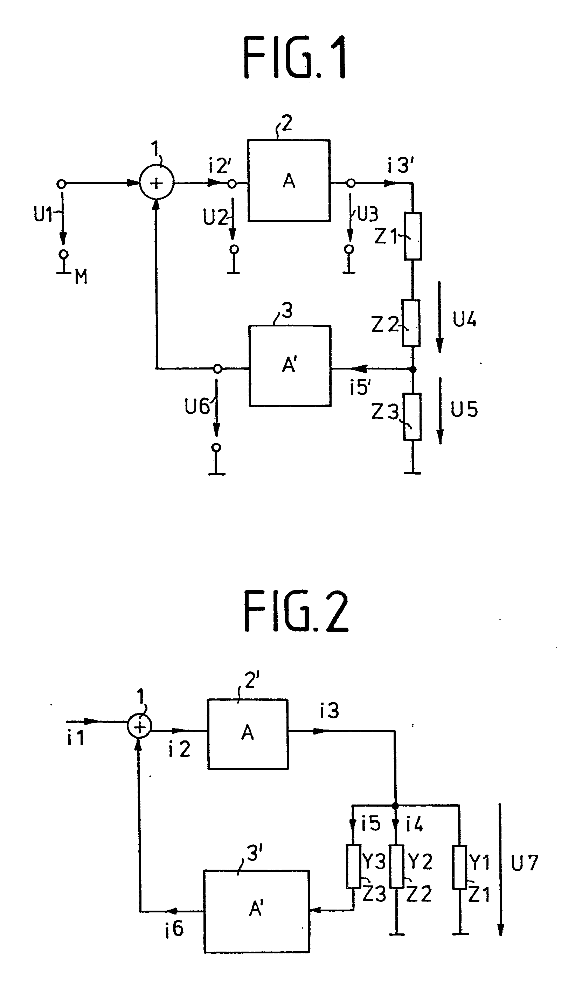

An der Schaltungsanordnung nach Fig. 1 liegt am Eingang als Eingangsgrösse die Spannung $U1$, die einer Überlagerungsstelle 1 zugeführt wird. Dieser Überlagerungsstelle 1 folgt eine Übertragungsstrecke 2, auf welche wiederum eine Impedanz, bestehend aus Ersatzimpedanzen $Z1$, $Z2$, folgt. Die Übertragungsstrecke 2 ist also der aus den Ersatzimpedanzen $Z1$, $Z2$ gebildeten Impedanz vorgeschaltet, und zwar innerhalb eines Mitkopplungskreises, zu dem auch noch eine Nachbildung $Z3$ und eine Rückführung 3 gehören.

So wie der Übertragungsstrecke 2 ein Übertragungsfaktor $A$ zugeordnet werden kann als Verhältnis ihrer Ausgangsgrösse (Ausgangsspannung) $U3$ zu ihrer Eingangsgrösse (Eingangsspannung) $U2$, so kann in entsprechender Weise der Rückführung 3 ein Übertragungsfaktor $A'$ zugeordnet werden als Verhältnis der zugehörigen Ausgangsgrösse (Ausgangsspannung) $U6$ zur zugeordneten Eingangsgrösse (Eingangsspannung) $U5$, die dem Spannungsabfall an der Nachbildung $Z3$ entspricht. Die Spannung $U6$ wird zusammen mit der Eingangsspannung $U1$ der Schaltungsanordnung der Überlagerungsstelle 1 zur additiven Überlagerung zugeführt.

Es ist ersichtlich, dass bei nichtlinearem Verhalten der Ersatzimpedanz $Z2$ (beispielsweise der Hauptinduktivität eines Übertragers) der Strom durch die Impedanz $Z1$, $Z2$ trotz sinusförmiger Spannung $U3$ gegenüber der Sinusform verzerrt sein wird. Dem entsprechend ist der Spannungsabfall an der Ersatzimpedanz $Z1$ verzerrt, so dass sich als Differenz zwischen der Spannung $U3$ und dem Spannungsabfall an $Z1$ für $U4$ ebenfalls ein verzerrter Verlauf ergibt, wenn zunächst einmal $U5$ = Null gesetzt wird.

Bei einem Übertrager ist es aber erwünscht, dass bei sinusförmiger Eingangsspannung U1 und auch U3 die Spannung U4 ebenfalls sinusförmig ist, damit die Ausgangsspannung an der Sekundärwicklung des Übertragers ebenfalls sinusförmig wird. Dass U4 von dieser gewünschten, sinusförmigen Form abweicht, liegt an der unerwünschten Abweichung, die durch Z1 hervorgerufen wird in Form des an dieser Ersatzimpedanz abfallenden Spannungsabfalls.

Zur Kompensation dieser Abweichung ist zunächst die Nachbildung Z3 vorgesehen, durch welche die Ersatzimpedanz Z1, welche die unerwünschte Abweichung hervorruft, ganz oder teilweise nachgebildet ist. Diese Nachbildung Z3 liegt in Reihe zur Impedanz Z1, Z2, so dass der durch die Impedanz fliessende Strom an Z3 einen Spannungsabfall U5 hervorruft, der im Idealfall genau dem unerwünschten Spannungsabfall an Z1 proportional ist. Über die Rückführungen 3 gelangt die Spannung U5, multipliziert mit dem Übertragungsfaktor A' als Spannung U6 zur Überlagerungsstelle 1, so dass durch den Mitkopplungszweig, der durch die Rückführung 3 und die Überlagerungsstelle 1 gebildet wird, eine Grösse (Spannung) U6 in Abhängigkeit von der Nachbildungsspannung U5 zur eingangsseitigen Überlagerung in der Überlagerungsstelle 1 zurückgeführt wird, von welcher Nachbildungsspannung U5 letztlich ein mit dem Übertragungsfaktor A multiplizierter Anteil in der Spannung U3 enthalten ist und damit die gänzliche oder teilweise Kompensation oder sogar Überkompensation des unerwünschten Spannungsabfalls an der Ersatzimpedanz Z1 ermöglicht. Auf diese Weise gelingt es, dafür zu sorgen, dass die Spannung U4 tatsächlich die gewünschte Form hat, also beispielsweise die Sinusform der Eingangsspannung U1 der Schaltungsanordnung. Es wird also erreicht, dass U4 proportional ist zu U1.

Anhand der folgenden Berechnung lässt sich dies zeigen, wobei die Voraussetzung gemacht wurde, dass die Eingangsströme i2' bzw. i5' für die Übertragungsstrecke 2 bzw. Rückführung 3 annähernd gleich Null sind, was gewährleistet ist, wenn es sich um Verstärkereingangsströme handelt:

$$U2 = U1 + U6 \tag{1}$$

$$U3 = A \cdot U2 \tag{2}$$

$$U4 = \frac{U3 \cdot Z2}{Z1 + Z2 + Z3} \tag{3}$$

$$U5 = \frac{U3 \cdot Z3}{Z1 + Z2 + Z3} \tag{4}$$

$$U6 = U5 \cdot A' \tag{5}$$

$$\frac{U4}{U1} = \frac{A \cdot Z2}{Z1 + Z2 + Z3 - Z3 \cdot A \cdot A'} \tag{6}$$

Es wird U4 ~ U1, wenn gilt:

$$\frac{A \cdot Z2}{Z1 + Z2 + Z3 - Z3 \cdot A \cdot A'} = \text{constant} \tag{7}$$

Die Gleichung lässt sich am leichtesten erfüllen, wenn

A = constant

und

$$Z1 + Z3 = Z3 \cdot A \cdot A' \tag{8}$$

$$A' = \frac{Z1 + Z3}{A \cdot Z3} \tag{9}$$

Aus Gleichung (9) sieht man, dass für die Übertragungsfaktoren A, A' lineare Faktoren gewählt werden können, und zwar in jedem Falle dann, wenn Z1 und Z3 linear sind, aber auch dann, wenn bei einer nichtlinearen Ersatzimpedanz Z1 die nachgebildete Impedanz Z3 proportional zu Z1 ist. Ist z.B. Z3 = Z1, dann ergibt sich für Gleichung (9): A' = 2/A.

Es ist auch zulässig, dass die Übertragungsfaktoren A, A' eine (u.U. auch frequenzabhängige) Phasenverschiebung bewirken. Dies kann zu einer (frequenzabhängigen) Phasenverschiebung zwischen den Spannungen U1 und U4 führen. Ausgehend von der Gleichung (6) lässt sich für diesen Fall ebenfalls eine Berechnung entsprechend den Gleichungen 7 bis 9 durchführen.

In Fig. 2 ist eine zu Fig. 1 duale Schaltungsanordnung gezeigt, bei der ähnliche Bezugszeichen 1, 2', 3' wie in Fig. 1 gewählt sind und den Spannungen U1 bis U6 nun Ströme i1 bis i6 entsprechen. Die Impedanzen Z1 bis Z3 aus Fig. 1 sind in Fig. 2 ersetzt durch einander parallelgeschaltete komplexe Leitwerte Y1 bis Y3, wobei Y3 die Nachbildung zu Y1 ist. Y2 entspricht der gewünschten Ersatzimpedanz Z2 in Fig. 1 und wird von einem Strom i4 durchflossen, der infolge einer unerwünschten Abweichung von der gewünschten Form abweicht. Die gewünschte Form kann proportional zu dem Eingangsstrom i1 der Schaltungsanordnung sein, wobei auch eine Phasenverschiebung zugelassen sein kann. Die gewünschte Form (und dies gilt auch für die Spannung U4 von Fig. 1) kann aber auch von der Eingangsgrösse der Schaltungsanordnung abweichen, beispielsweise wenn durch die gesamte Schaltungsanordnung eine bewusste Verzerrung oder Entzerrung herbeigeführt werden soll.

Für den Fall, dass i4 proportional sein soll zu i1, wobei der Proportionalitätsfaktor gleich A ist, gilt die folgende Berechnung, wobei die Eingangsspannungen der Blöcke 2' und 3' in Fig. 2 gleich Null gesetzt worden sind.

$$i2 = i1 + i6 \tag{1'}$$

$$i3 = A \cdot i2 \tag{2'}$$

$$i4 = \frac{i3 \cdot Y2}{Y1 + Y2 + Y3} \tag{3'}$$

$$i5 = \frac{i3 \cdot Y3}{Y1 + Y2 + Y3} \tag{4'}$$

$$i6 = i5 \cdot A' \tag{5'}$$

$$\frac{i4}{i1} = \frac{A \cdot Y2}{Y1+Y2+Y3-Y3 \cdot A \cdot A'} \qquad (6')$$

$$A' = \frac{Y1+Y3}{A \cdot Y3} \qquad (9')$$

Die dabei unterstellten Voraussetzungen sind denen bei der ersten Berechnung analog.

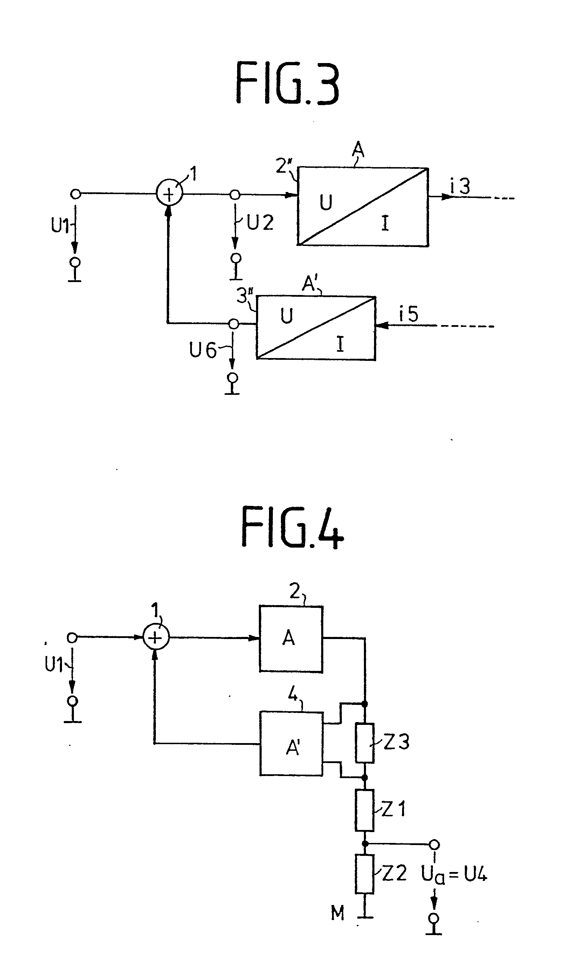

In Fig. 3 ist eine Abwandlung für die Fig. 2 dargestellt, indem nämlich die Übertragungsstrecke 2'' mit dem Übertragungsfaktor A und die Rückführung 3'' mit dem Übertragungsfaktor A' nunmehr als Spannungs-Strom- bzw. Strom-Spannungswandler ausgeführt sind, realisierbar als Verstärker mit hochohmigem Eingang und niederohmigem Ausgang bzw. umgekehrt.

In dualer Weise ist eine Abänderung der Fig. 1 derart möglich, dass in der Überlagerungsstelle 1 statt einer Überlagerung von Spannungen eine Überlagerung von Strömen wie in Fig. 2 stattfindet.

In Fig. 4 ist eine von Fig. 1 abgeleitete Schaltungsanordnung dargestellt, bei der jedoch die als Nachbildung dienende Impedanz Z3 nicht an Massepotential sondern am Ausgang der Übertragungsstrecke 2 liegt. Der an Z3 abfallende Spannungsabfall wird hier den beiden Eingängen eines Differenzverstärkers 4 zugeführt, welcher die Rückführung mit dem Übertragungsfaktor A' bildet. Bei geeigneter Bemessung der Schaltungsanordnung gemäss Gleichung (9) ist die Ausgangsspannung Ua = U4 proportional zur Eingangsspannung U1 der Schaltungsanordnung.

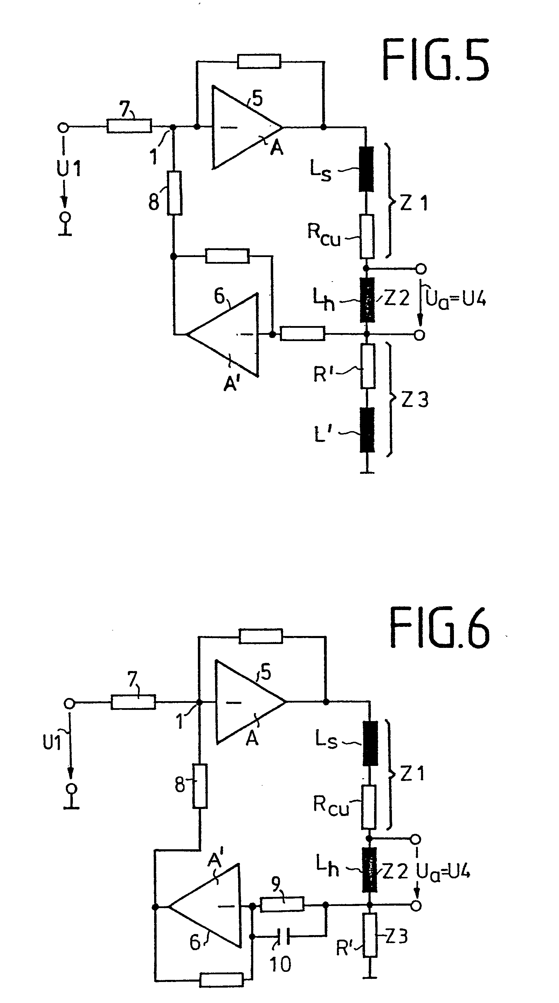

Fig. 5 stellt eine von Fig. 1 abgeleitete Schaltungsanordnung dar, bei der zunächst einmal die Übertragungsstrecke 2 in Fig. 1 durch einen gegengekoppelten Operationsverstärker 5 und die Rückführung 3 durch einen eben solchen Verstärker 6 realisiert ist. Die Impedanz ist die Primärimpedanz eines Übertragers. Z2 wird durch die Hauptinduktivität $L_h$ gebildet, an der als Ausgangsspannung Ua die gewünschte Spannung U4 abgegriffen werden kann, die proportional ist zur Eingangsspannung U1 der Schaltungsanordnung.

Die andere Ersatzimpedanz Z1 wird gebildet durch die Streuinduktivität $L_s$ und den Kupferwiderstand $R_{cu}$. Als Nachbildungsimpedanz sind in Serie zur Eingangsimpedanz Z1+Z2 des Übertragers vorgesehen: R' und L', zusammen Z3 bildend. Zur Realisierung der Überlagerungsstelle 1 sind Widerstände 7 und 8 vorgesehen. Bei Einhaltung der Gleichung (9) lässt sich mit dieser Schaltungsanordnung der unerwünschte Einfluss des Kupferwiderstandes $R_{cu}$ und der Streuinduktivität $L_s$ kompensieren.

Wenn R' und/oder L' etwas kleiner gewählt werden als $R_{cu}$ bzw. $L_s$ und/oder A und/oder A' etwas kleiner gewählt werden, als es Gleichung (9) vorsieht, wird der störende Spannungsabfall an Z1 nicht voll kompensiert, sondern unterkompensiert, was aus Stabilitätsgründen vorteilhaft sein kann. Es wird dann nur ein Teil des störenden Spannungsabfalles an Z1 kompensiert oder nur ein Teil von Z1 durch Z3 nachgebildet.

Fig. 6 zeigt ein weiteres von Fig. 1 und Fig. 5 abgeleitetes Ausführungsbeispiel. Es dient wiederum zur Kompensation des Kupferwiderstandes $R_{cu}$ und der Streuinduktivität $L_s$. Zur Nachbildung der Impedanzkomponente $R_{cu}$ ist wieder ein Widerstand R' vorgesehen. Vom Spannungsabfall an diesem Widerstand wird jedoch zur Nachbildung der Streuinduktivität $L_s$ mit Hilfe des Widerstandes 9 und des Kondensators 10 eine phasenverschobene Spannung abgeleitet, die dem Spannungsabfall an L' in Fig. 5 entspricht. Wenn man den Widerstand 9 und den Kondensator 10 dem Verstärker 6 zurechnet, so hat der Übertragungsfaktor A' dieser Rückführung ausser einem Realteil auch noch einen Imaginärteil in Form einer frequenzabhängigen Komponente. Dies ist ein Beispiel dafür, dass sich die Gleichung (9) auch mit einem frequenzabhängigen Übertragungsfaktor A' erfüllen lässt.

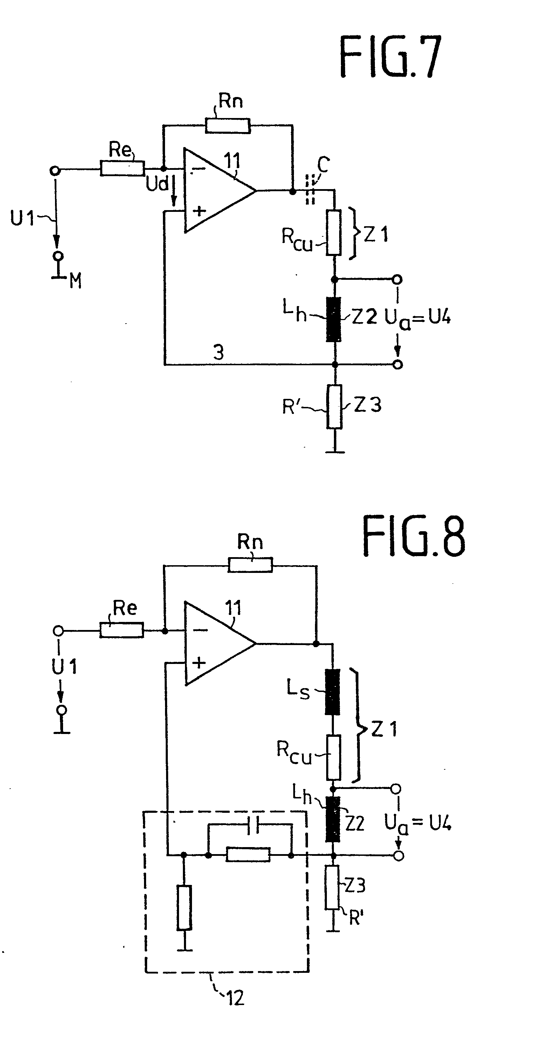

In Fig. 7 ist eine Schaltungsanordnung zur Kompensation des Kupferwiderstandes $R_{cu}$ dargestellt, die aus der DE-A1-2 901 567 (Anmeldetag: 13.1.79, Offenlegungstag 24.7.80) bekannt ist, bei der die Rückführung 3 lediglich aus einer Leitung besteht, die zum nichtinvertierenden Eingang eines gegengekoppelten Differenzverstärkers 11 führt, der zusammen mit seinem anderen, invertierenden Eingang zugleich die Überlagerungsstelle 1 bildet. Wie eine kurze Rechnung unter der Voraussetzung Ud = Null ergibt, muss zur Kompensation des Spannungsabfalls an $R_{cu}$ die Gleichung erfüllt werden:
R' = k' Re $R_{cu}$ / Rn mit k' = 1 (10)

Bei k' = 1 wird eine Kompensation des primären Kupferwiderstandes $R_{cu}$ des Übertragers und eine Verringerung des übertragerbedingten Klirrfaktors erreicht. Bei k' > 1 (Überkompensation) sind beide Effekte in abgeschwächter Form vorhanden. Für eine Serienfertigung ist z.B. ein Wert von ca. 1,1 anzustreben, um zu verhindern, dass durch Bauteiltoleranzen ein Wert von k' < 1 erreicht wird, da dieser, bei der üblichen kapazitiven Ankupplung des Übertragers über die gestrichelt eingezeichnete, dem Übertrager vorgeschaltete Koppelkapazität C zu einer niederfrequenten Schwingneigung der Gesamtschaltung führt.

Bei k' < 1 (Unterkompensation) kann, sofern der Übertrager nicht kapazitiv angekoppelt ist, auch der sekundärseitige Kupferwiderstand kompensiert werden, jedoch steigt der Klirrfaktor mit sinkendem k' wieder an, falls der Übertrager einen Eisenkern aufweist.

Von der Fig. 7 abgeleitet, zeigt die Fig. 8 ein weiteres Ausführungsbeispiel zur Kompensation von Kupferwiderstand und Streuinduktivität. Ähnlich wie in Fig. 6 ist durch R' nur der Kupferwiderstand $R_{cu}$ nachgebildet, und vom Spannungsabfall an der Nachbildung wird über ein phasenverschiebendes R-C-Glied 12 letztlich eine Nachbildungsspannung erzeugt und dem nichtinvertierenden Eingang des Verstärkers 11 zugeführt, die doch wieder dem Spannungsabfall an der Ersatzimpedanz Z1 entspricht. Man kann auch R' und das Netzwerk 12 zusammengenommen als Nachbildung der Ersatzimpedanz Z1 betrachten.

Es ist ersichtlich, dass die Erfindung in vielfältiger Weise abgewandelt werden kann. Ist z.B. Z2 die auf die Primärseite transformierte Hauptinduktivität eines Übertragers, dann kann Z1 der primärseitige Kupferwiderstand und/oder die vorgeschaltete Koppelkapazität und/oder die auf die Primärseite transformierte Streuinduktivität sein. Ist Z2 der auf die Primärseite transformierte Lastwiderstand eines Übertragers, so kann Z1 der auf die Primärseite transformierte Gesamtkupferwiderstand und/oder die auf die Primärseite transformierte Summe aus dem Kupferwiderstand des Übertragers und eines nachgeschalteten weiteren Wandlers sein.

Ist der Übertragungsfaktor A′ der Rückführung linear und frequenzunabhängig, so lässt sich Gleichung (9) bzw. (9′) durch eine geeignet gewählte Impedanz der Nachbildung Z3 erfüllen. Ist Z3 linear und frequenzunabhängig, so lässt sich Gleichung (9) bzw. (9′) durch einen geeignet gewählten Übertragungsfaktor A′ erfüllen. Wird eine Unterkompensation gewünscht, so kann A′ den durch Gleichung (9) bzw. (9′) gegebenen Wert unterschreiten bzw. bei einer gewünschten Überkompensation entsprechend überschreiten.

Gleichung (9) bzw. (9′) braucht möglicherweise auch nur in einem begrenzten Amplituden- und/oder Frequenzbereich durch geeignete Massnahmen näherungsweise erfüllt zu werden. Die Übertragungsfaktoren A, A′ können sowohl durch Verstärker als auch durch Dämpfungsglieder realisiert werden, wie zur Erfüllung und Annäherung der Gleichung (9) bzw. (9′) erforderlich.

**Patentansprüche**

1. Schaltungsanordnung
a) mit Verstärker, dem die eingangsseitige Impedanz eines Übertragers nachgeschaltet ist, die zwei in Serie zueinander geschalteten Ersatzimpedanzen (Z1, Z2) entspricht, von denen sich die zweite (Z2) im Betrieb nichtlinear verhält, wobei in Serie zur Impedanz und in einem Rückkopplungskreis eine Messimpedanz zur Bildung einer Grösse vorgesehen ist, die vom Strom durch die Messimpedanz abhängt und die mittels einer Rückführung im Rückkopplungskreis einer veränderlichen Eingangsgrösse der Schaltungsanordnung überlagert ist, dadurch gekennzeichnet, dass die Überlagerung mitkoppelnd erfolgt und die Messimpedanz in Form einer Abbildungsimpedanz (Z3) als Abbild wenigstens einer Komponente der ersten Ersatzimpedanz (Z1) derart vorgesehen ist, dass zwischen der ersten Ersatzimpedanz (Z1), der Abbildungsimpedanz (Z3), dem Übertragungsfaktor A (Verhältnis von Ausgangsgrösse (U3; i3) zur Eingangsgrösse (U2; i2)) der Übertragungsstrecke, welche der Impedanz innerhalb des Rückkopplungskreises vorgeschaltet ist, sowie dem Übertragungsfaktor A′ (Verhältnis von Ausgangsgrösse (U6; i6) zur Eingangsgrösse (U5; i5) der von der Abbildungsimpedanz (Z3) ausgehenden Rückführung (3, 3′)) folgende Beziehung innerhalb eines Amplituden- und eines Frequenzbereiches wenigstens angenähert erfüllt ist: A′ = (Z1 + Z3)/A · Z3,

b) jedoch unter Ausschluss einer Schaltunganordnung mit Verstärker mit dem Verstärkerausgang nachgeschalteter, mit einem Wirkwiderstand $R_{cu}$ behafteter Primärwicklung eines Ausgangsübertragers und mit einem Gegenkopplungswiderstandswert Rn zwischen dem Verstärkerausgang und einem ersten Verstärkereingang sowie mit einem Serienwiderstandswert Re zwischen diesem Verstärkereingang und der zugehörigen Eingangsklemme der Schaltungsanordnung, die derart ausgestaltet ist, dass ein Mitkopplungsweg vorgesehen ist, welcher von der mit der Primärwicklung verbundenen Seite eines Mitkopplungswiderstandes R′ ausgeht, der in Serie zur Primärwicklung des Ausgangsübertragers angeordnet ist, wobei

$$k = Rn/Re = k' \cdot R_{cu}/R'$$

mit $0 < k < \infty$ und $0 < k' < \infty$ derart gewählt sind, dass an der primären Induktivität des Ausgangsübertragers eine Spannung (Ua) entsteht, bei welcher der schädliche Einfluss des primären Wirkwiderstandes $R_{cu}$ auf den Klirrfaktor verringert ist.

2. Schaltungsanordnung mit Verstärker, dem die eingangsseitige Impedanz eines Übertragers nachgeschaltet ist, die in Dualität zur Schaltungsanordnung nach dem Merkmal a) des Anspruches 1 zwei parallel zueinander geschalteten Ersatzimpedanzen (Z1 = 1/Y1, Z2 = 1/Y2) entspricht, von denen sich die zweite (Z2) im Betrieb nichtlinear verhält, wobei parallel zur Impedanz und in einem Rückkopplungskreis eine Messimpedanz zur Bildung einer Grösse vorgesehen ist, die von der Spannung an der Messimpedanz abhängt und die mittels einer Rückführung im Rückkopplungskreis einer veränderlichen Eingangsgrösse der Schaltungsanordnung überlagert ist, dadurch gekennzeichnet, dass die Überlagerung mitkoppelnd erfolgt und die Messimpedanz in Form einer Abbildungsimpedanz (Z3) als Abbild wenigstens einer Komponente der ersten Ersatzimpedanz (Z1) in dualer Weise zum Merkmal a) des Anspruches 1 vorgesehen ist.

3. Schaltunganordnung nach Anspruch 1 oder 2, dadurch gekennzeichnet, dass die Impedanz im Rückkopplungskreis enthalten ist.

4. Schaltungsanordnung nach Anspruch 1, 2 oder 3, dadurch gekennzeichnet, dass die zweite Ersatzimpedanz (Z2) die auf die Primärseite transformierte Hauptinduktivität ($L_h$) des Übertragers enthält (Fig. 5 bis 8).

5. Schaltungsanordnung nach Anspruch 4, dadurch gekennzeichnet, dass die erste Ersatzimpedanz (Z1) den primärseitigen Kupferwiderstand ($R_{cu}$) des Übertragers enthält (Fig. 5 bis 8).

6. Schaltungsanordnung nach Anspruch 4 oder 5, dadurch gekennzeichnet, dass die erste Ersatzimpedanz (Z1) die auf die Primärseite des Übertragers transformierte Streuinduktivität ($L_s$) enthält (Fig. 5, 6, 8).

7. Schaltungsanordnung nach Anspruch 4, 5 oder 6, dadurch gekennzeichnet, dass die erste Ersatzimpedanz (Z1) eine dem Übertrager vorgeschaltete Koppelkapazität (C) enthält (Fig. 7).

8. Schaltungsanordnung nach einem der Ansprüche 1 bis 7, dadurch gekennzeichnet, dass die zweite Ersatzimpedanz·(Z2) den auf die Primärseite transformierten Lastwiderstand des Übertragers enthält.

9. Schaltungsanordnung nach einem der Ansprüche 1 bis 8, dadurch gekennzeichnet, dass die erste Ersatzimpedanz (Z1) den auf die Primärseite transformierten Gesamtkupferwiderstand des Übertragers enthält.

10. Schaltungsanordnung nach Anspruch 8, dadurch gekennzeichnet, dass die erste Ersatzimpedanz (Z1) die auf die Primärseite transformierte Summe aus dem auf die Primärseite transformierten Gesamtkupferwiderstand des Übertragers und aus dem Kupferwiderstand eines nachgeschalteten elektromagnetischen Wandlers enthält.

11. Schaltungsanordnung nach Anspruch 10, dadurch gekennzeichnet, dass wenigstens einer der Übertragungsfaktoren A, A' innerhalb des für die Übertragung vorgesehenen Frequenzbereiches frequenzunabhängig ist.

12. Schaltungsanordnung nach Anspruch 11, dadurch gekennzeichnet, dass einer der Übertragungsfaktoren A, A' innerhalb des vorgesehenen Frequenzbereiches gleich Eins ist.

13. Schaltungsanordnung nach Anspruch 10 oder 11, dadurch gekennzeichnet, dass wenigstens einer der Übertragungsfaktoren A, A' durch einen Verstärker (5, 6) realisiert ist (Fig. 5, 6).

14. Schaltungsanordnung nach einem der Ansprüche 1 bis 13, dadurch gekennzeichnet, dass die Ausgangsgrösse (U6; i6) der Rückführung (3; 3') so gewählt ist, dass sich eine Überkompensation des nichtlinearen Verhaltens ergibt.

15. Schaltungsanordnung nach einem der Ansprüche 1 bis 13, dadurch gekennzeichnet, dass die Ausgangsgrösse (U6; i6) der Rückführung (3; 3') so gewählt ist, dass sich eine Unterkompensation des nichtlinearen Verhaltens ergibt.

16. Schaltungsanordnung nach Anspruch 2 und 5 mit Eingangsserienwiderstand Re und dem Verstärkerausgang nachgeschalteter, mit einem Wirkwiderstand Rcu behafteter Primärwicklung des ausgangsseitigen Übertragers und mit einem Gegenkopplungsweg, der vom Verstärkerausgang über einen Gegenkopplungswiderstand Rn zu einem ersten Verstärkereingang führt, dem der Eingangsserienwiderstand Re vorgeschaltet ist, dessen dem Verstärker (11) abgewandtes Ende eine der Eingangsklemmen der Schaltungsanordnung bildet, dadurch gekennzeichnet, dass zwischen der nicht mit dem Verstärkerausgang verbundenen Klemme der Primärwicklung ($L_h$, Rcu) und der anderen Eingangsklemme (M) der Schaltungsanordnung ein Mitkopplungswiderstand R' angeordnet ist, von dessen mit der Primärwicklung verbundener Seite ein Mitkopplungsweg (3) zu einem zweiten Verstärkereingang führt, wobei $k = Rn/Re = k' \cdot Rcu/R'$ gewählt ist mit $0 < k < \infty$ und $0 < k' < \infty$.

17. Schaltunganordnung nach Anspruch 16, dadurch gekennzeichnet, dass $0,1 < k < 100$ gewählt ist.

18. Schaltunganordnung nach Anspruch 16 oder 17, dadurch gekennzeichnet, dass $1 < k' < 10$ gewählt ist.

19. Schaltungsanordnung nach Anspruch 18, dadurch gekennzeichnet, dass $1 < k' < 1,1$ gewählt ist.

20. Schaltungsanordnung nach einem der Ansprüche 16 bis 19, dadurch gekennzeichnet, dass $k' \approx 1$ gewählt ist.

21. Schaltungsanordnung nach Anspruch 17, dadurch gekennzeichnet, dass $k < 1$ gewählt ist.

22. Schaltungsanordnung nach einem der Ansprüche 1 bis 21, dadurch gekennzeichnet, dass der Übertrager einen magnetisierbaren Kern aufweist.

**Claims**

1. Circuit arrangement
a) with amplifier, behind which is conncected the input side impedance of a transformer corresponding to two equivalent impedances (Z1, Z2), which are connected in series each with the other and of which the second (Z2) behaves non-linearly in operation, wherein a measuring impedance is provided in series with the impedance and in a feedback circuit for the formation of a magnitude which depends on the current through the measuring impedance and which is superimposed by means of a feedback in the feedback circuit on a variable input magnitude of the circuit arrangement, characterised thereby, that the superimposition takes place regeneratively and the measuring impedance is provided in the form of an image impedance (Z3) as image of at least one component of the first equivalent impedance (Z1) in such a manner that the relationship $A' = (Z1 + Z3)/A \cdot Z3$ is at least approximately fulfilled within an amplitude range and a frequency range by the first equivalent impedance (Z1), the image impedance (Z3), the transfer factor A (ratio of output magnitude (U3; i3) to input magnitude (U2; i2)) of the transfer path, which is connected in front of the impedance within the feedback circuit as well as the transfer factor A' (ratio of output magnitude (U6; i6) to input magnitude (U5; i5) of the feedback (3, 3') emanating from the image impedance (Z3)),

b) however subject to exclusion of a circuit arrangement with amplifier and with a primary winding, connected behind the amplifier output and having a dissipative resistance $R_{cu}$, of an output transformer and with a degenerative feedback resistance value Rn between the amplifier output and a first amplifier input as well as with a series resistance value Re between this amplifier input and the associated input terminal of the circuit arrangement which is strucutred in such a manner that a regenerative feedback path is provided, which emanates from the side, connected with the primary winding, of a regenerative feedback resistor R', which is arranged in series with the primary winding of the output transformer, wherein

$$k = Rn/Re = k' \cdot R_{cu}/R'$$

are chosen with $0 < k < \infty$ and $0 < k' < \infty$ in such a manner that a voltage (Ua), at which the deleterious influence of the primary dissipative resistance $R_{cu}$ on the distortion factor is reduced, arises at the primary inductance of the output transformer.

2. Circuit arrangement with amplifier, behind which is connected the input side impedance of a transformer, which impedance in duality to the circuit arrangement according to the feature (a) of the claim 1 corresponds to two equivalent impedances (Z1 = 1/Y1, Z2 = 1/Y2), which are connected in parallel each with the other and of which the second (Z2) behaves non-linearly in operation, wherein a measuring impedance is provided in parallel with the impedance and in a feedback circuit for the formation of a magnitude which depends on the voltage across the measuring impedance and which is superimposed by means of a feedback in the feedback circuit on a variable input magnitude of the circuit arrangement, characterised thereby, that the superimposition takes place regeneratively and the measuring impedance is provided in the form of an image impedance (Z3) as image of at least one component of the first equivalent impedance (Z1) in dual manner to the feature (a) of the claim 1.

3. Circuit arrangement according to claim 1 or 2, characterised thereby, that the impedance is contained in the feedback circuit.

4. Circuit arrangement according to claim 1, 2 or 3, characterised thereby, that the second equivalent impedance (Z2) contains the main inductance $(L_h)$, transformed to the primary side, of the transformer (Figs. 5 to 8).

5. Circuit arrangement according to claim 4, characterised thereby, that the first equivalent impedance (Z1) contains the primary side copper resistance $(R_{cu})$ of the transformer (Figs. 5 to 8).

6. Circuit arrangement according to claim 4 or 5, characterised thereby, that the first equivalent impedance (Z1) contains the stray inductance $(L_s)$, transformed to the primary side, of the transformer (Figs. 5, 6 and 8).

7. Circuit arrangement according to claim 4, 5 or 6, characterised thereby, that the first equivalent impedance (Z1) contains a coupling capacitance (C) connected in front of the transformer (Fig. 7).

8. Circuit arrangement according to one of the claims 1 to 7, characterised thereby, that the second equivalent impedance (Z2) contains the load resistance, transformed to the primary side, of the transformer.

9. Circuit arrangement according to one of the claims 1 to 8, characterised thereby, that the first equivalent impedance (Z1) contains the total copper resistance, transformed to the primary side, of the transformer.

10. Circuit arrangement according to claim 8, characterised thereby, that the first equivalent impedance (Z1) contains the sum, transformed to the primary side, of the total copper resistance, transformed to the primary side, of the transformer and the copper resistance of an electromagnetic transducer connected therebehind.

11. Circuit arrangement according to claim 10, characterised thereby, that at least one of the transfer factors A and A' is independent of frequency within the frequency range provided for the transmission.

12. Circuit arrangement according to claim 11, characterised thereby, that one of the transfer factors A and A' is equal to unity within the provided frequency range.

13. Circuit arrangement according to claim 10 or 11, characterised thereby, that at least one of the transfer factors A and A' is realisable through an amplifier (5, 6) (Figs. 5 and 6).

14. Circuit arrangement according to one of the claims 1 to 13, characterised thereby, that the output magnitude (U6; i6) of the feedback (3; 3') is so chosen that an overcompensation of the nonlinear behaviour results.

15. Circuit arrangement according to one of the claims 1 to 13, characterised thereby, that the output magnitude (U6; i6) of the feedback (3; 3') is so chosen that an undercompensation of the nonlinear behaviour results.

16. Circuit arrangement according to claim 2 and 5, with input series resistor Re and primary winding, connected behind the amplifier output and having a dissipative resistance $R_{cu}$, of the transformer at the output side and with a degenerative feedback path which leads from the amplifier output through a degenerative feedback resistor Rn to a first amplifier input, in front of which the input series resistor Re is connected, the end of which remote from the amplifier (11) forms one of the input terminals of the circuit arrangement, characterised thereby, that a regenerative feedback resistor R', from the side of which connected with the primary winding a regenerative feedback path (3) leads to a second amplifier input, is arranged between that terminal of the primary winding $(L_h, Rcu)$, which is not connected with the amplifier output, and the other input terminal (M) of the circuit arrangement, wherein $k = Rn/Re = k' \cdot Rcu/R'$ is chosen with $0 < k < \infty$ and $0 < k' < \infty$.

17. Circuit arrangement according to claim 16, characterised thereby, that $0.1 < k < 100$ is chosen.

18. Circuit arrangement according to claim 16 or 17, characterised thereby, that $1 < k' < 10$ is chosen.

19. Circuit arrangement according to claim 18, characterised thereby, that $1 < k' < 1.1$ is chosen.

20. Circuit arrangement according to one of the claims 16 to 19, characterised thereby, that k' is chosen to be approximately equal to unity.

21. Circuit arrangement according to claim 17, characterised thereby, that $k < 1$ is chosen.

22. Circuit arrangement according to one of the claims 1 to 21, characterised thereby, that the transformer displays a magnetisable core.

## Revendications

1. Circuit qui

a) comporte un amplificateur suivi de l'impédances côté entrée d'un transformateur, qui correspond à deux impédances équivalentes ($Z1$, $Z2$) montées en série l'une avec l'autre, dont la deuxième ($Z2$) se comporte de façon non linéaire en service, où une impédance de mesure est prévue, en série avec l'impédance et dans une boucle de réaction, pour former une grandeur qui dépend du courant traversant l'impédance de mesure et qui, au moyen d'un dispositif de réinjection dans la boucle de réaction, est superposée à une grandeur d'entrée variable du circuit, caractérisé en ce que la superpositon s'effectue à rétroaction et l'impédance de mesure est prévue sous forme d'une impédance de reproduction ($Z3$) comme reproduction d'au moins une composante de la première impédance équivalente ($Z1$), de manière que soit satisfaite, au moins approximativement, dans une gamme d'amplitudes et une gamme de fréquences, la relation $A' = (Z1+Z3)/A \cdot Z3$, entre la première impédance équivalente ($Z1$), l'impédance de reproduction ($Z3$), le facteur de transmission A (rapport de la grandeur de sortie ($U3$; $i3$) à la grandeur d'entrée ($U2$; $i2$) de la voie de transmission qui précède l'impédance de la boucle de réaction, ainsi que le facteur de transmission $A'$ (rapport de la grandeur de sortie ($U6$; $i6$) à la grandeur d'entrée ($U5$; $i5$) du dispositif de réinjection (3, 3')), partant de l'impédance de reproduction ($Z3$), mais

b) à l'exclusion d'un circuit comportant un amplificateur à la sortie duquel est relié l'enroulement primaire – présentant une résistance effective $R_{cu}$ – d'un transformateur de sortie et comportant une résistance de contre-réaction Rn entre la sortie de l'amplificateur et une première entrée de l'amplificateur, ainsi qu'une résistance série Re entre cette entrée d'amplificateur et la borne d'entrée correspondante du circuit, qui est réalisé de manière que soit formée une voie de rétroaction qui part du côté relié à l'enroulement primaire d'une résistance de rétroaction $R'$ qui est branchée en série avec l'enroulement primaire du transformateur de sortie, où

$$k = Rn/Re = k' \cdot R_{cu}/R'$$

avec $0 < k < \infty$ et $0 < k' < \infty$ sont choisis de manière qu'à l'inductance primaire du transformateur de sortie apparaisse une tension ($Ua$) à laquelle l'influence nuisible de la résistance effective primaire $R_{cu}$ sur le taux de distorsion totale est réduite.

2. Circuit comportant un amplificateur suivi de l'impédance côté entrée d'un transformateur, qui, en dualité avec le circuit selon a) de revendication 1, correspond à deux impédances équivalentes ($Z1 = 1/Y1$, $Z2 = 1/Y2$) montées en parallèle l'une avec l'autre, dont le deuxième ($Z2$) se comporte de façon non linéaire en service, où une impédance de mesure est prévue, en parallèle avec l'impédance et dans une boucle de réaction, pour former une grandeur qui dépend de la tension sur l'impédance de mesure et qui, au moyen d'un dispositif de réinjection dans la boucle de réaction, est superposée à une grandeur d'entrée variable du circuit, caractérisé en ce que la superposition s'effectue à rétroaction et l'impédance de mesure est prévue sous forme d'un impédance de reproduction ($Z3$) comme reproduction d'au moins une composante de la première impédance équivalente ($Z1$), de manière duale par rapport à a) de la revendication 1.

3. Circuit selon la revendication 1 ou 2, caractérisé en ce que l'impédance est contenue dans la boucle de réaction.

4. Circuit selon la revendication 1, 2 ou 3, caractérisé en ce que la seconde impédance équivalente ($Z2$) contient l'inductance principale ($L_h$), transformée sur le côté primaire, du transformateur (figures 5 à 8).

5. Circuit selon la revendication 4, caractérisé en ce que la première impédance équivalente ($Z1$) contient la résistance de cuivre ($R_{cu}$) du côté primaire du transformateur (figures 5 à 8).

6. Circuit selon la revendication 4 ou 5, caractérisé en ce que la première impédance équivalente ($Z1$) contient l'inductance de dispersion ($L_s$) transformée sur le côté primaire du transformateur (figures 5, 6, 8).

7. Circuit selon la revendication 4, 5 ou 6, caractérisé en ce que la première impédance équivalente ($Z1$) contient une capacité de couplage (C) montée en série avec lui avant le transformateur (figure 7).

8. Circuit selon une des revendications 1 à 7, caractérisé en ce que la seconde impédance équivalente ($Z2$) contient la résistance de charge, transformée sur le côté primaire, du transformateur.

9. Circuit selon une des revendications 1 à 8, caractérisé en ce que la première impédance équivalente ($Z1$) contient la résistance de cuivre totale, transformée sur le côté primaire, du transformateur.

10. Circuit selon la revendication 8, caractérisé en ce que la première impédance équivalente ($Z1$) contient la somme, transformée sur le côté primaire, de la résistance de cuivre totale transformée sur le côté primaire du transformateur et de la résistance de cuivre d'un transducteur électromagnétique monté à la suite.

11. Circuit selon la revendication 10, caractérisé en ce que l'un au moins des facteurs de transmission A, $A'$ est indépendant de la fréquence dans la gamme de fréquences prévue pour la transmission.

12. Circuit selon la revendication 11, caractérisé en ce que l'un des facteurs de transmission A, $A'$ est égal à un dans la gamme de fréquences prévue.

13. Circuit selon la revendication 10 ou 11, caractérisé en ce que l'un au moins des facteurs de transmission A, A' est réalisé par un amplificateur (5, 6) (figures 5, 6).

14. Circuit selon une des revendications 1 à 13, caractérisé en ce que la grandeur de sortie (U6; i6) du dispositif de réinjection (3; 3') est choisie de manière qu'on obtienne une sur-compensation du comportement non linéaire.

15. Circuit selon une des revendications 1 à 13, caractérisé en ce que la grandeur de sortie (U6; i6) du dispositif de réinjection (3; 3') est choisie de manière qu'on obtienne une sous-compensation du comportement non linéaire.

16. Circuit selon les revendications 2 et 5, comportant une résistance série d'entrée Re et un enroulement primaire – présentant une résistance effective $R_{cu}$ – du transformateur côté sortie, ainsi qu'une voie de contre-réaction qui mène de la sortie de l'amplificateur à travers une résistance de contre-réaction Rn à une première entrée de l'amplificateur, devant laquelle est intercalée la résistance série d'entrée Re, dont l'extrémité éloignée de l'amplificateur (11) forme l'une des bornes d'entrée du circuit, caractérisé en ce qu'une résistance de rétroaction R' est disposée entre la borne d'enroulement primaire ($L_h$, $R_{cu}$) non reliée à la sortie d'amplificateur et l'autre borne d'entrée (M) du circuit et une voie de rétroaction (3) menant du côté relié à l'enroulement primaire de cette résistance à une seconde entrée d'amplificateur, où $k = Rn/Re = k' \cdot R_{cu}/R'$ avec $0 < k < \infty$ et $0 < k' < \infty$.

17. Circuit selon la revendication 16, caractérisé en ce que 0, $1 < k < 100$.

18. Circuit selon la revendication 16 ou 17, caractérisé en ce que $1 < k' < 10$.

19. Circuit selon la revendication 17, caractérisé en ce que $1 < k' < 1,1$.

20. Circuit selon une des revendications 16 à 19, caractérisé en ce que $k' \approx 1$.

21. Circuit selon la revendication 17, caractérisé en ce que $k < 1$.

22. Circuit selon une des revendications 1 à 21, caractérisé en ce que le transformateur possède un noyau magnétisable.

# FIG.1

# FIG.2

# FIG.3

# FIG.4

FIG.5

FIG.6

# FIG.7

# FIG.8